Europäisches Patentamt

(19) European Patent Office

Office européen des brevets

(11) Veröffentlichungsnummer: **0 067 925**
**B1**

(12) **EUROPÄISCHE PATENTSCHRIFT**

(45) Veröffentlichungstag der Patentschrift:
22.04.87

(51) Int. Cl.⁴: **G 01 C 22/02, H 03 K 21/40**

(21) Anmeldenummer: 82101718.3

(22) Anmeldetag: 05.03.82

(54) **Schaltungsanordnung zur Speicherung eines mehrstelligen dekadischen Zählwerts einer von einem Fahrzeug zurückgelegten Wegstrecke.**

(30) Priorität: 15.06.81 DE 3123654

(43) Veröffentlichungstag der Anmeldung:
29.12.82 Patentblatt 82/52

(45) Bekanntmachung des Hinweises auf die Patenterteilung:
22.04.87 Patentblatt 87/17

(84) Benannte Vertragsstaaten:
DE FR GB

(56) Entgegenhaltungen:
GB - A - 1 322 869
US - A - 3 760 372

PATENTS ABSTRACTS OF JAPAN, Band 1, Nr. 163, 22.
Dezember 1977, Seite 9100 E 77

(73) Patentinhaber: VDO Adolf Schindling AG,
Gräfstrasse 103, D-6000 Frankfurt/Main (DE)

(72) Erfinder: Henry, Peter, Sindlinger Strasse 50,
D-6234 Hattersheim 3 (DE)

(74) Vertreter: Könekamp, Herbert, Dipl.-Ing., Sodener
Strasse 9, D-6231 Schwalbach (DE)

## Beschreibung

Die Erfindung betrifft eine Schaltungsanordnung zur Erzeugung und nichtflüchtigen Speicherung eines mehrstelligen Zählwerts, der einer von einem Fahrzeug zurückgelegten Wegstrecke entspricht, mit einem elektrische Zählimpulse abgebenden Signalgeber, der einen Zähler speist.

Eine derartige Schaltungsanordnung ist bekannt (Patents Abstracts of Japan, Band 1, Nr. 163, 22. Dezember 1977, Seite 9100 E 77). Die bekannte Schaltungsanordnung enthält einen statischen, nichtflüchtigen Halbleiterzähler, dessen Ausgänge an Decoder angeschlossen sind. Die Decoder speisen Anzeigeelemente.

Bekannt ist auch ein Magnetkerne als Speicherelemente enthaltender Zähler, der Zählimpulse in einem einschrittigen Code zählt (US-A-3 760 372).

Der Erfindung liegt die Aufgabe zugrunde, eine Schaltungsanordnung der eingangs beschriebenen Gattung derart weiterzuentwickeln, dass die Speicherelemente der Halbleiteranordnung zur nichtflüchtigen Speicherung des mehrstelligen und mehrdekadischen Zählwerts durch Löschzeiten möglichst wenig und insgesamt gleichmässiger beansprucht werden.

Die Aufgabe wird erfindungsgemäss dadurch gelöst, dass als Zähler ein mehrdekadischer Zähler vorgesehen ist, in dem jede Dekade zum Zählen des Zählwerts in einem einschrittigen Code ausgebildet ist, dass je eine Gruppe von Floating-Gate-Speicherzellen eines nichtflüchtigen RAM-Speichers zur Speicherung je eines codierten Zählwerts einer Dekade adressierbar ist und dass bei vorgegebenen Zählwerten Mittel zum zyklischen Vertauschen der Adressen der Speicherplätze der niedrigsten Dekaden angesteuert sind.

Mit dieser Schaltungsanordnung mit einem nichtflüchtigen Speicher aus Floating-Gate-Speicherzellen wird eine Speicherzeit grösser als 10 Jahre bei einer Umgebungstemperatur von 70 °C realisiert. Der Arbeitstemperaturbereich von −25 °C bis +70 °C wird eingehalten. In vorteilhafter Weise kann die Logik zur Steuerung des Speichers auf dem gleichen Chip wie die Speicherzellen realisiert werden. Die Speicherladezeit, d.h. die Zeit zum Einschreiben einer logischen 1 (L) ist unabhängig von der Anzahl der Schreib- und Löschzyklen und bleibt typischerweise kleiner als 20 ms. Die Zeit zum Löschen des Speichers hängt von der Anzahl der Löschzyklen ab. Um die Anzahl der Löschzyklen möglichst gering und damit die Löschzeiten kurz zu halten, wird der Zählwert in einem einschrittigen Code in den nichtflüchtigen Speicher eingespeichert. Dadurch wird beim Übergang von einem mehrstelligen Zählwert zu dem nächsten mehrstelligen Zählwert nur eine Stelle ihren Wert von einem ersten binären Zustand, z.B. L auf einen zweiten binären Zustand, z.B. Null wechseln. Der Zählvorgang bzw. die Bildung des Zählwertes wird bei der Schaltungsanordnung in dem einschrittigen Code von der Speicherung des Zählwerts getrennt und der Zählwert wird dekadenweise gebildet und gespeichert. Während eines den gesamten Zahlenvorrat eine Dekade durchlaufenden Zählzyklus wechselt jedes Zählbit nur einmal von dem ersten binären Zustand L auf den zweiten binären Zustand Null. Damit tritt während eines Zählzyklus in sämtlichen Speicherzellen, die einer Dekade zugeordnet unter einer Adresse erreichbar sind, während eines Zählzyklus nur ein einziger Löschzyklus ein. Die Löschzeit wird also gering gehalten.

In der üblichen Organisation eines mehrdekadischen Zählers und Speichers wird eine niedrige Dekade die Werte ihrer Stellen beim Hochzählen öfter wechseln als die Stellen der nächsthöheren Dekade. Um deswegen die Löschzeiten für die Speicherzellen der niedrigeren Dekade während der Speicherzeit des nichtflüchtigen Speichers möglichst wenig ansteigen zu lassen, sind die bei gegebenen Zählwerten gesteuerten Mittel zum zyklischen Vertauschen der Adressen der Speicherplätze der niedrigsten Dekaden vorgesehen.

Damit wird die Zuordnung der Dekaden des Zählers zu denjenigen der Speicherplätze bei vorgegebenen Zählwerten, typischerweise alle 100.000 Kilometer, geändert.

Als nichtflüchtiger Speicher gebildet aus Foating-Gate-Speicherzellen kann beispielsweise vorteilhaft ein Non-Volatile RAM der Firma SGS-Ates verwendet werden.

Die Mittel zur Codierung des Zählwerts sind vorzugsweise in dem Code von Libaw-Craig ausgebildet.

Im einzelnen ist zur Übertragung des Zählwertes aus dem Zähler in den nichtflüchtigen Speicher die Schaltungsanordnung in der Weise ausgebildet, dass die Zählerausgänge je einer der niedrigsten fünf Dekaden über einen als Multiplexer ausgebildeten Dekadenzähler zyklisch mit den mit je einer Adresse adressierbaren Speichereingängen verbindbar sind, dass ein aufeinanderfolgende Dekaden zählender Adressenzähler vorgesehen ist, der den Dekadenwähler sowie einen ersten Eingang eines Codierers steuert, dessen zweiter Eingang von wenigstens einer Dekade (6. Dekade) des Zählers gespeist wird, und dass ein Adressausgang des Codierers zum zyklischen Vertauschen der Adressen der niedrigsten fünf Dekaden mit dem Speicher verbunden ist.

Bei dieser Schaltungsanordnung wird also der Zählwert in vorteilhafter Weise dekadenweise vorzugsweise beginnend mit der höchsten Dekade im Multiplexbetrieb in den nichtflüchtigen Speicher übertragen. Dabei wird in Abhängigkeit von dem erreichten Zählwert, typischerweise alle 100.000 Kilometer, die Zuordnung der niedrigsten fünf Dekaden des Zählers zu den fünf entsprechenden Adressen des nichtflüchtigen Speichers zyklisch vertauscht. Die Zuordnung der höchsten 6. Dekade des Zählers zu der Adresse des nichtflüchtigen Speichers der 6. Dekade bleibt unverändert. Der Adressenzähler steuert ausser dem Dekadenwähler den Codierer, der ausserdem in Abhängigkeit von dem Zählwert alle 100.000 Kilometer zum zyklischen Vertauschen der Adressen in dem nichtflüchtigen Speicher für die niedrigsten fünf Dekaden vorgesehen ist. – Diese Schaltungsanordnung kann in raumökonomischer Weise auf einen Chip realisiert werden.

Um sicherzustellen, dass in der Schaltungsanordnung bei Änderung der Batteriespannung, insbesondere Spannungsausfall, nicht der Speicherinhalt zerstört wird ist gemäss Anspruch 6 ein Pufferkondensator vorgesehen.

Der Pufferkondensator liefert so viel Energie, dass die Übertragung eines Zählwerts aus dem Zähler in den nichtflüchtigen Speicher auch dann abgeschlossen wird, wenn während eines Übertragungszyklus die Betriebsspannung ausfällt.

In besonders vorteilhafter Weise ist die Schaltungsanordnung mit den Mitteln zur Datensicherung gemäss Anspruch 7 ausgestattet:

Bei dieser Ausbildung der Mittel zur Datensicherung kann die Kapazität des Pufferkondensators sehr klein sein, da im Falle eines Betriebsspannungsausfalls während eines Schreibvorganges nur der Schreibvorgang für die jeweils übertragene Dekade zu Ende geführt wird und anschliessend der Betriebsspannungsausfall durch Eingabe eines bestimmten binären Zustands in das 6. Bit der jeweils angesprochenen Adresse markiert wird. Da die zu diesem 6. Bit gehörende Speicherzelle nur für dieses Sonderfall vorgesehen ist, kann sie schnell beschrieben werden. Der Zählerstand kann nach Wiederherstellen der Betriebsspannung dadurch wieder restauriert werden, weil das zusätzliche 6. Bit bei dem Ausfall der Betriebsspannung nur dann auf einen vorgegebenen binären Zustand, typischerweise L gesetzt wurde, wenn der Inhalt der zu dieser Adresse gehörenden Dekade gerade geändert worden ist. Das bedeutet, dass der Zähler gerade einen Übertrag in diese Dekade gezählt hat, so dass die niedrigeren Dekaden den Wert Null haben, auf den die Adressen nach Wiederherstellen der Betriebsspannung gesetzt werden. War vor dem Ausfall der Betriebsspannung nach dem letzten Übertragungszyklus der Zählwert nicht geändert worden, so wird kein zusätzliches Bit einer Dekade markiert, da der alte Zahlenwert sehr rasch in den nichtflüchtigen Speicher überschrieben wird.

Die Erfindung wird im folgenden anhand einer Zeichnung mit fünf Figuren erläutert. Es zeigen:

Figur 1 ein Blockschaltbild eines elektronischen Tachometers mit Wegstreckenanzeige auf der Basis von Flüssigkristallen und mit einem nichtflüchtigen Speicher;

Figur 2 ein Blockschaltbild des nichtflüchtigen Speichers mit dem zugehörigen Zähler und der zugehörigen Steuerlogik;

Figur 3 im Blockschaltbild die Speicherzuordnung zu den Dekaden des Zählers;

Figur 4 den Zählcode und

Figur 5 eine Funktionstabelle der Adressen für die Speicherplätze für die einzelnen Dekaden in Abhängigkeit von vorgegebenen Zählintervallen (je 100.000 Kilometer).

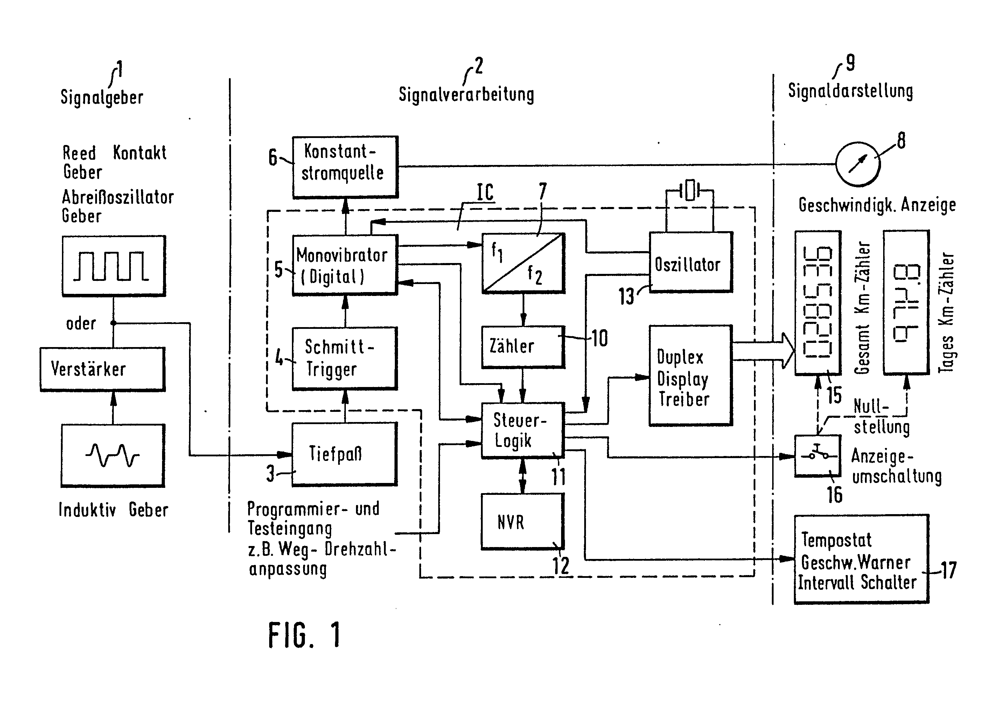

In dem Blockschaltbild in Figur 1 ist in dem Abschnitt 1 der Signalgeber bezeichnet, der als Reed-Kontaktgeber oder Abreissoszillatorgeber oder aber als Induktivgeber mit nachgeschaltetem Verstärker aufgebaut sein kann. – An den Signalgeber schliesst sich eine Schaltungsanordnung 2 zur Signalverarbeitung an. Sie ist im wesentlichen auf einem Halbleiterchip aufgebaut. Von einem Tiefpass 3, der die elektrischen Zählimpulse von dem Signalgeber empfängt, wird ein Schmitt-Trigger 4 auf dem Halbleiterchip beaufschlagt, so dass vorgegeben geformte Impulse einen Monovibrator 5 auf dem Halbleiterchip beaufschlagen. Der Monovibrator erzeugt Impulse konstanter Impulsbreite die einerseits eine Konstantstromquelle 6 – ausserhalb des Halbleiterchips sowie einen Frequenzwandler 7 auf dem Halbleiterchip steuern. Die Konstantsstromquelle beaufschlagt ein Galvanometer 8 als Geschwindigkeitsanzeige in einer Gruppe 9 zur Signaldarstellung.

Durch den Frequenzwandler 7 wird ein Zähler 10 gespeist, dessen Zählerstand über eine Steuerlogik 11 gesteuert in einen nichtflüchtigen Speicher 12 einzuspeisen ist. Zähler 10, Steuerlogik 11 und nichtflüchtiger Speicher 12 sind ebenfalls Bestandteil des integrierten Schaltkreises, ebenso wie ein Oszillator 13 als Taktgeber und eine von der Steuerlogik beaufschlagte Treiberstufe 14.

Die Treiberstufe 14 beaufschlagt eine Kilometeranzeige 15, die den in dem nichtflüchtigen Speicher 12 gespeicherten Zählwert als Angabe der von dem Fahrzeug zurückgelegten Kilometer darstellt. Die Kilometeranzeige kann über eine Anzeigeumschaltung 16 von einer Gesamtanzeige auf eine Tageskilometerzähleranzeige umgeschaltet werden.

Von der Steuerlogik 11 kann ferner ein Geschwindigkeitsregler, ein Geschwindigkeitswarner oder ein Intervallschalter 17 entsprechend der gefahrenen Geschwindigkeit bzw. der zurückgelegten Wegstrecke gesteuert werden.

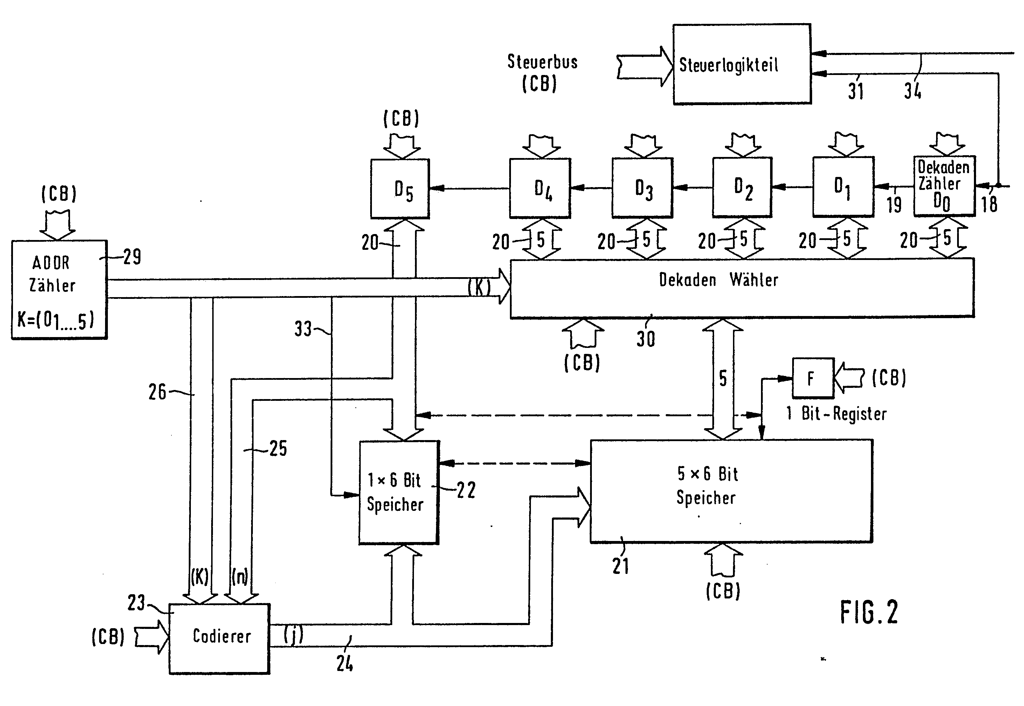

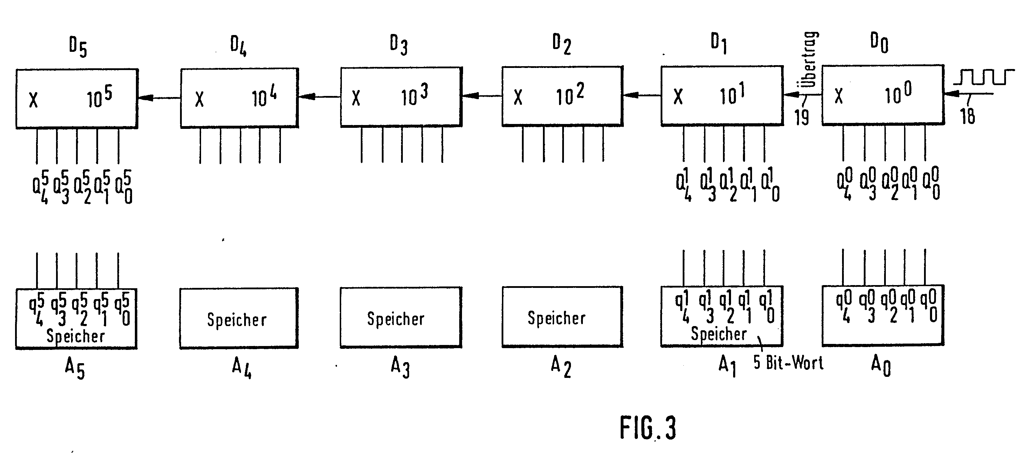

In den Figuren 2 und 3 sind mit $D_0$, $D_1$, $D_2$, $D_3$, $D_4$, $D_5$ sechs Dekaden eines Zählers bezeichnet. Jede Dekade ist als Schiebezähler mit fünf Bit aufgebaut. In die erste Dekade $D_0$ wird über eine Leitung 18 der Zählimpuls – gegebenenfalls nach Umformung – eingespeist. Eine Übertragsleitung 19, die Dekade $D_0$ mit der Dekade $D_1$ verbindet, speist in die nächsthöhere Dekade $D_1$ einen Impuls ein, wenn ein Zählzyklus der Dekade $D_0$ durchlaufen ist. In gleicher Weise werden Überträge in die Dekaden $D_2$, $D_3$, $D_4$, $D_5$ eingespeist. Jeder Zähler weist fünf Zählerausgänge 20 auf, die in Figur 3 für die erste Dekade mit $Q_0^0$, $Q_1^0$, $Q_2^0$, $Q_3^0$, $Q_4^0$ bezeichnet sind. Dementsprechend sind die Zählerausgänge für die zweite Dekade $D_1$ mit $Q_0^1$, $Q_1^1$ usw. bitweise bezeichnet usw. bis $Q_0^5$, $Q_1^5$, $Q_2^5$, $Q_3^5$, $Q_4^5$ der sechsten Dekade $D_5$.

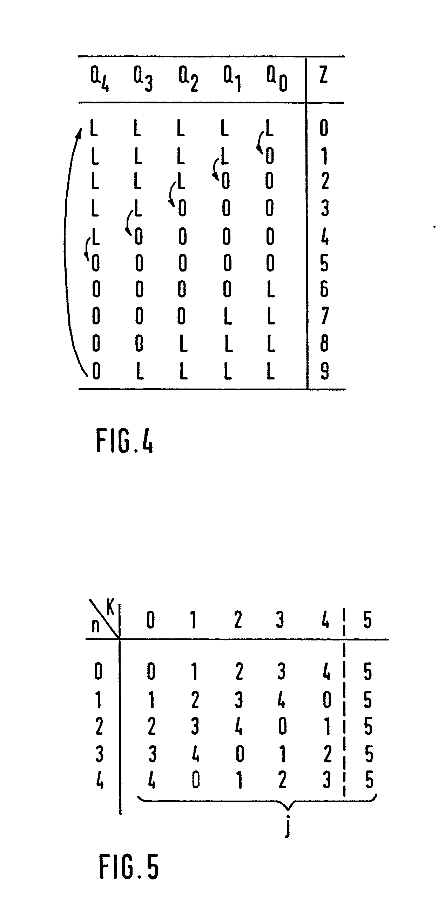

In der Zustandstabelle in Figur 5 ist dargestellt, wie jede Dekade des Sechs-Dekaden-Zählers 10 in einem Zählcode nach Libaw-Craig verknüpft ist:

In der Zustandstabelle sind mit Z die Zählimpulse bezeichnet, denen die Zählerzustände bzw. Ausgänge $Q_0$ bis $Q_4$ bitweise zugeordnet sind. Aus der Zustandstabelle ist ersichtlich, dass bei Auftreten jedes Zählimpulses Z höchstens ein Bit von dem binären Zustand L auf den binären Zustand Null wechselt, z.B. bei dem ersten Zählimpuls in dem untersten, dem Ausgang $Q_0$ zugeordneten Bit. Die Wechsel von dem binären Zustand Null auf den binären Zustand L ab dem sechsten Zählimpuls sind hier von weniger grossem Interesse, da ihnen kein Löschen einer Speicherzelle, sondern im Gegenteil das Einschreiben einer binären Zahl L zugeordnet ist.

Der Zählerstand jeder Dekade $D_0$ bis $D_5$ wird in einem Wort eines nichtflüchtigen Speichers aus Floating-Gate-Speicherzellen gespeichert. Jedes Wort umfasst zur Speicherung eines dekadischen Werts fünf Bit und ein sechstes zusätzliches Bit zur Datensicherung, die weiter unten erläutert wird.

In Figur 2 ist der mit fünf Worten adressierbare nichtflüchtige Speicherteil, der den untersten fünf Dekaden zugeordnet ist, mit 21 bezeichnet. Der Speicherteil 22, der der höchsten Dekade zugeordnet ist, ist mit einer weiteren aus sechs Bit bestehenden Adresse adressierbar. In Figur 3 sind die Speicheradressen mit $A_0$, $A_1$ bis $A_5$ bezeichnet und die Speichereingänge sind mit $q_0^0$, $q_1^0$, $q_2^0$, $q_3^0$, $q_4^0$ für die unterste Dekade bzw. $q_0^1$, $q_1^1$, $q_2^1$, $q_3^1$, $q_4^1$ für die nächsthöhere Dekade bezeichnet. Die Darstellung in Figur 3 der Speicheradressen zu den Dekaden des Zählers liegt dabei während eines bestimmten Zählintervalls, hier während der ersten 100.000 Kilometer vor. Die Zuordnung wird, wie unten erläutert, in Abhängigkeit von dem Zählerstand bzw. dem Zählwert alle 100.000 Kilometer für die untersten fünf Dekaden geändert, während die Zuordnung für die oberste Dekade $D_5$ zu dem Speicherteil 22 immer erhalten bleibt.

In Figur 5 ist dargestellt, wie die Zuordnung der Adressen j für die Speicherung der Werte der untersten fünf Dekaden K = 0, 1, 2, 3, 4 in Abhängigkeit von den Zählintervallen 0, 1, 2, 3, 4, d.h. alle 100.000 Kilometer zyklisch vertauscht wird. Die Speicheradresse zur Speicherung der 6. Dekade K = 5 bleibt hingegen immer gleich j = 5.

Die Funktionstabelle für die Bildung der Adressen ist in Figur 2 in dem Codierer 23 realisiert. Demzufolge führt eine Busleitung 24 für die Adressen zu den beiden Speicherteilen 21 und 22. Der Codierer wird über eine Busleitung 25 mit einer Information über das gerade vorliegende Zählintervall gespeist, welches der Dekade $D_5$ entnommen wird, da das Zählintervall 100.000 Kilometer beträgt. Eine weitere Busleitung 26 speist in den Codierer eine Information ein, welcher Wert einer der Dekaden $D_0$ bis $D_5$ jeweils in den nichtflüchtigen Speicherteil 21 zu übertragen ist.

Über einen Steuerbus 27, der in einem Steuerlogikteil 28 mit Steuerdaten beaufschlagt wird, werden die Steuerinformationen zu dem Adressenzähler 29, welcher die Busleitung 26 speist, zu dem Codierer 23, zu dem nichtflüchtigen Speicher 21, 22 und zu einem Dekadenwähler 30 übertragen.

Der Dekadenwähler 30 ist als Multiplexer aufgebaut und bestimmt durch den Adresszähler 29 über die Busleitung 26 gesteuert, der Zählwert welcher Dekade jeweils in den nichtflüchtigen Speicher zu übertragen ist. Die Abfrage der Dekaden $D_0$ bis $D_5$ erfolgt dabei von der höchsten zur niedrigsten Dekade, d.h. ausgehend von $D_5$.

Die beschriebenen Funktionsgruppen können Bestandteile eines Mikroprozessors sein, ebenso wie die noch nachfolgend zu beschreibenden Funktionsgruppen zur Datensicherung.

Aus Figur 2 ist noch ersichtlich, dass der Steuerlogikteil über eine Leitung 31 mit den Zählimpulsen gespeist wird. Eine weitere Leitung 32 ist von der Busleitung 26 abgezweigt und führt nur zu dem Speicherteil 22.

Zu der Ausführung des nichtflüchtigen Speichers wird noch als vorteilhaft bemerkt, dass dieser nur 35 Speicherzellen zur Speicherung des sechs Dekaden umfassenden Zählwerts aufzuweisen braucht.

Die Schaltungsanordnung arbeitet in der Weise, dass in den sechs dekadischen Zähler Zählimpulse über die Leitung 18 eingespeist werden, so dass die Dekaden $D_0$ bis $D_5$ entsprechend der eingespeisten Anzahl Zählimpulse hochgezählt werden und der Zählwert in dem Zähler als in dem Code von Libaw-Craig codierte Zahl vorliegt. Zur Übertragung der einzelnen Dekaden des Zählwerts wird der Adresszähler 29 durch den Steuerlogikteil 28 gesteuert in Betrieb gesetzt, so dass die Dekaden von $D_5$ bis $D_0$ nacheinander in den nichtflüchtigen Speicher 21, 22 übertragen werden. Zunächst wird der Inhalt der Dekade $D_5$ in den Speicherteil 22 eingespeist, was durch ein Signal auf der Leitung 33 veranlasst wird, wenn der Adresszähler die Dekade K = 5 gezählt hat. Die Zählerstände der Dekaden $D_4$ bis $D_0$ werden anschliessend zyklisch im Zeitmultiplexbetrieb durch den Dekadenwähler 30 in den Speicherteil 21 des nichtflüchtigen Speichers eingeschrieben, wozu der Dekadenwähler durch Signale in der Busleitung 26 gesteuert wird. Gleichzeitig bestimmt der Codierer 23, der ebenfalls Signale von der Busleitung 26 entsprechend dem zu übertragenden Dekadenwert, aber auch Signale von der Busleitung 25 über das jeweilige Zählintervall enthält, die Adresse des Fünf-Bit-Worts in dem Speicherteil 21, unter der der Inhalt der gleichzeitig durch den Dekadenwähler angewählten Dekade in den nichtflüchtigen Speicherteil 21 abzuspeichern ist. Dieser Vorgang wiederholt sich so lange, bis während eines Übertragungszyklus auch die unterste Dekade $D_0$ abgefragt ist. Die Zuordnung der Adressen in dem Speicherteil 21 ändert sich durch den Adressenzähler 29 gesteuert alle 100.000 Kilometer, während die Zuordnung der Adresse j = 5 zu dem Speicherteil 22 fest bleibt.

Zur Datensicherung muss sichergestellt sein, dass bei einer Unterbrechung der Stromversorgung bzw. starkem Spannungsabfall während des Übertragungsvorgangs eines Zählerstandes in den nichtflüchtigen Speicher ausreichend Energie zur Verfügung steht, um diesen Vorgang so zu beenden, dass keine Informationsverluste auftreten. Die zum Abschluss des Vorgangs und Datensicherung benötigte Energie wird einem in der Zeichnung nicht dargestellten Kondensator entnommen, der eine vorteilhaft kleine Kapazität hat.

Zur Datensicherung ist jede Speicheradresse des nichtflüchtigen Speichers um ein sechstes Bit erweitert, d.h. zur Speicherung eines Worts gehört eine sechste Speicherzelle. Weiterhin ist ein 1-Bit-Register F vorgesehen, welches mit den sechsten Speicherzellen aller Adressen in Verbindung steht. Weiterhin wird der Steuerlogikteil 28 zusätzlich über eine Leitung 34 durch ein von einer Betriebsspannungsüberwachungseinrichtung abgegebenes Signal gespeist.

Wenn während eines Übertragungsvorganges des Zählwerts einer Dekade, z.B. der Dekade $D_3$ die Betriebsspannung ausfällt, wird die Übertragung des Zählerstands dieser Dekade $D_3$ gleichwohl vollständig zu Ende geführt. Anschliessend wird, wenn der Inhalt der Dekade $D_3$ vor der Übertragung dieses Inhalts gerade geändert wurde, in die sechste Speicherzelle unter dieser Adresse eine logische 1 (= L) eingeschrieben. Diese sechste Speicherzelle, die normalerweise nicht beansprucht wird, kann sehr schnell beschrieben werden. Wegen des Spannungsausfalls werden die Inhalte der Dekaden $D_2$, $D_1$, $D_0$ in diesem Übertragungszyklus nicht mehr übertragen. Beim Wiederherstellen der Betriebsspannung wird aber geprüft, ob eine sechste Speicherzelle auf L gesetzt wurde. Da dies hier in der sechsten Speicherzelle zutrifft, die zu der Adresse gehört, unter der der Wert der Dekade $D_3$ übertragen wird, werden beim Wiederherstellen der Betriebsspannung unter den Adressen für die Dekaden $D_2$, $D_1$ und $D_0$ der Wert Null in den Speicherteil 21 eingespeist. Dies bedeutet, dass in dem Falle, in dem die sechste Speicherzelle zu der Adresse, unter der der Wert der Dekade $D_3$ gespeichert wurde, L gesetzt worden ist, der Zähler in den Dekaden $D_2$, $D_1$, $D_0$ einen Übertrag bis zur Dekade $D_3$ gemacht hat, so dass die Inhalte der Adressen zu $D_2$, $D_1$, $D_0$ Null sein müssen.

Anstelle der beschriebenen Methode der Datensicherung kann unter Beibehaltung der aus fünf Bit bestehenden Adressen des Speichers ein Pufferkondensator einer grösseren Kapazität verwendet werden, um die Übertragung der Werte sämtlicher Dekaden in einem Zyklus abzuschliessen.

Die beschriebene Schaltungsanordnung ermöglicht es, einen Kilometer-Zählerstand zuverlässig langfristig zu speichern, so dass zur Anzeige Flüssigkristallzellen verwendet werden können, die sich durch absolute Geräuschfreiheit, grosse Ziffernhöhe bei geringer Einbautiefe und leichter Trennbarkeit der Anzeige der Wegstrecke von der Elektronik- und Geschwindigkeitsanzeige auszeichnen.

**Patentansprüche**

1. Schaltungsanordnung zur Erzeugung und nichtflüchtigen Speicherung eines mehrstelligen Zählwerts, der einer von einem Fahrzeug zurückgelegten Wegstrecke entspricht, mit einem elektrische Zählimpulse abgebenden Signalgeber, der einen Zähler speist, dadurch gekennzeichnet, dass als Zähler ($D_0$, $D_1$, $D_2$, $D_3$, $D_4$, $D_5$) ein mehrdekadischer Zähler vorgesehen ist, in dem jede Dekade zum Zählen des Zählwerts in einem einschrittigen Code ausgebildet ist, dass je eine Gruppe von Floating-Gate-Speicherzellen eines nichtflüchtigen RAM-Speichers (21, 22) zur Speicherung je eines codierten Zählwerts einer Dekade adressierbar ($A_0$, $A_1$ ... $A_5$ in Fig. 3) ist und dass bei vorgegebenen Zählwerten Mittel (Codierer 23) zum zyklischen Vertauschen der Adressen der Speicherplätze ($A_0$, $A_1$ ... $A_5$) der niedrigsten Dekaden ($D_1$, $D_2$, $D_3$, $D_4$) angesteuert sind.

2. Schaltungsanordnung nach Anspruch 1, dadurch gekennzeichnet, dass die Mittel zur Codierung des Zählwerts in dem Code von Libaw-Craig ausgebildet sind.

3. Schaltungsanordnung nach Anspruch 1, dadurch gekennzeichnet, dass die Zählerausgänge (20) je einer der niedrigsten fünf Dekaden ($D_0$ bis $D_4$) über einen als Multiplexer ausgebildeten Dekadenwähler (30) zyklisch mit den mit je einer Adresse adressierbaren Speichereingängen verbindbar sind, dass ein aufeinanderfolgende Dekaden zählender Adressenzähler (29) vorgesehen ist, der den Dekadenwähler (30) sowie einen ersten Eingang eines Codierers (23) steuert, dessen zweiter Eingang von wenigstens einer Dekade (6. Dekade $D_5$) des Zählers gespeist wird, und dass ein Adressenausgang (Busleitung 24) des Codierers zum zyklischen Vertauschen der Adressen der niedrigsten fünf Dekaden mit dem Speicher (Speicherteil 21) verbunden ist.

4. Schaltungsanordnung nach einem der Ansprüche 1 bis 3, dadurch gekennzeichnet, dass zur Datensicherung bei Ausfall der Betriebsspannung während eines den Zählerstand in den Speicher übertragenden Schreibvorgangs ein Pufferkondensator vorgesehen ist.

5. Schaltungsanordnung nach Anspruch 3 und 4, dadurch gekennzeichnet, dass jede Adresse ($A_0$, $A_1$ bis $A_5$) des nichtflüchtigen Speichers (21, 22) um ein zusätzliches Bit (6. Speicherzelle) erweitert ist, dass eine von einer Betriebsspannungsüberwachungseinrichtung gesteuerte Steuerlogik (Steuerlogikteil 28 und 1-Bit-Register F) derart aufgebaut ist, dass bei Betriebsspannungsausfall während des Übertragens des Zählerstands in den nichtflüchtigen Speicher (21, 22) mittels des Pufferkondensators der Schreibvorgang unter einer Adresse einer Dekade zu Ende geführt wird und anschliessend das zusätzliche Bit dieser Dekade gesetzt wird und dass bei dem nachfolgenden Einschalten der Betriebsspannung die Inhalte der Adressen der niedrigeren Dekaden auf eine fest vorgegebene Zahl (Null) gesetzt werden.

**Claims**

1. Circuit arrangement for the production and non-volatile storage of a multi-digit count value which corresponds to a distance travelled by a vehicle, with a signal emitter which issues electrical counting pulses and which feeds a counter, characterised in that as the counter ($D_0$, $D_1$, $D_2$, $D_3$, $D_4$, $D_5$) a multi-decade counter is provided wherein each decade for counting the count value is formed in a continuous progressive code, that each respective group of floating-gate storage celles of a non-volative RAM memory (21, 22) is addressable ($A_0$, $A_1$ ... $A_5$ in Fig. 3) for storing in each case one coded count value of a decade, and that at predetermined count values means (codes 23) are triggered for cyclic interchange of addresses of the storage locations ($A_0$, $A_1$ ... $A_5$) of the lowest decades ($D_1$, $D_2$, $D_3$, $D_4$).

2. Circuit arrangement according to claim 1, characterised in that the means for coding the count value are formed in the Libaw-Craig code.

3. Circuit arrangement according to claim 1, characterised in that the counter outputs (20) of each one of the lowest five decades ($D_0$ to $D_4$) are connectable cyclically, via a decade selector (30) constructed as a multiplexer, to the memory inputs addressable each with one address, that an address counter (29) is provided which counts successive decades and which controls the decade selector (30) and also a first input of a coder (23) whose second input is fed by at least one decade (6th decade $D_5$) of the counter, and that an address output (bus 24) of the coder is connected for cyclic interchange of the addresses of the lowest five decades with the memory (memory part 21).

4. Circuit arrangement according to one of claims 1 to 3, characterised in that a buffer capacitor is provided for data protection in the event of failure of the operating voltage during a write operation transferring the counter state into the memory.

5. Circuit arrangement according to claims 3 and 4, characterised in that each address ($A_0$, $A_1$ to $A_5$) of the non-volatile memory (21, 22) is extended by one additional bit (6th memory cell, that a control logic (control logic part 28 and 1-bit register F) controlled by an operating voltage monitoring device is so constructed that in the event of operating voltage failure during transfer of the counter state into the non-volatile memory (21, 22) the write operation under one address of a decade is brought to an end with the use of the buffer capacitor, and then the additional bit of this decade is set, and that when the operating voltage is next connected-up the contents of the addresses of the lower decades are set to a fixedly predetermined number (zero).

**Revendications**

1. Circuit pour la génération et la mémorisation rémanente d'une valeur de comptage à plusieurs chiffres correspondant à un trajet parcouru par un véhicule, ce circuit comportant un générateur de signaux qui délivre des impulsions de comptage électriques et alimente un compteur, circuit caractérisé par le fait qu'il est prévu, en tant que compteur ($D_0$, $D_1$, $D_2$, $D_3$, $D_4$, $D_5$), un compteur à plusieurs décades dans lequel chaque décade est réalisée pour compter la valeur de comptage selon un code cyclique à une seule progression; par le fait qu'un groupe respectif de cellules de mémorisation du type «porte flottante» d'une mémoire rémanente à accès aléatoire (21, 22) est adressable pour la mémorisation d'une valeur de comptage respective codée d'une décade ($A_0$, $A_1$ ... $A_5$) sur la figure 3); et par le fait que, en présence de valeurs de comptage prédéterminées, des moyens (codeur 23) sont commandés pour l'échange cyclique des adresses des zones de mémorisation ($A_0$, $A_1$ ... $A_5$) des décades les plus faibles ($D_1$, $D_2$, $D_3$, $D_4$).

2. Circuit selon la revendication 1, caractérisé par le fait que les moyens pour coder la valeur de comptage sont conçus d'après le code de Libaw-Craig.

3. Circuit selon la revendication 1, caractérisé par le fait que les sorties de comptage (20) de chacune des cinq décades les plus faibles ($D_0$ à $D_4$) peuvent être racccordées cycliquement, par l'intermédiaire d'un sélecteur de décades (30) réalisé sous la forme d'un multiplexeur, aux entrées de mémorisation adressables au moyen d'une adresse respective; par le fait qu'il est prévu un compteur d'adresses (29) qui, comptant des décades successives, commande aussi bien le sélecteur de décades (30) qu'une première entrée d'un codeur (23) dont la seconde entrée est alimentée par au moins une décade (sixième décade $D_5$) du compteur; et par le fait qu'une sortie d'adressage (ligne omnibus 24) du codeur est reliée à la mémoire (partie de mémorisation 21) en vue de l'échange cyclique des adresses des cinq décades les plus faibles.

4. Circuit selon l'une des revendications 1 à 3, caractérisé par le fait qu'un condensateur tampon est prévu pour sauvegarder les données en cas de défaillance de la tension de service, au cours d'un processus d'inscriptions transférant dans la mémoire la situation affichée par le compteur.

5. Circuit selon les revendications 3 et 4, caractérisé par le fait que chaque adresse ($A_0$, $A_1$ à $A_5$) de la mémoire rémanente (21, 22) est agrandie d'un bit supplémentaire (sixième cellule de mémorisation); par le fait qu'une unité de commande logique (partie de commande logique 28 et registre F à 1 bit), commandée par un dispositif de surveillance de la tension de service, est réalisée de telle sorte que, en cas de défaillance de la tension de service au cours du transfert de la situation affichée par le compteur à mémoire rémanente (21, 22), ce processus d'inscription sous une adresse d'une décade soit mené à terme, au moyen du condensateur tampon, après quoi le bit supplémantaire est affecté à cette décade et par le fait que, au cours de l'enclenchement successif de la tension de service, les contenus des adresses des décades plus faibles sont placés à un nombre fixe préétabli (zéro).

FIG. 1

Steuerbus (CB)

Steuerlogikteil

31  34

(CB)

$D_5$   $D_4$   $D_3$   $D_2$   $D_1$   Dekaden Zähler $D_0$

19   18

(CB)

ADDR Zähler — 29

K=($0_1$....5)

20 — 20 $\leftarrow$5   20 $\leftarrow$5   20 $\leftarrow$5   20 $\leftarrow$5   20 $\leftarrow$5

Dekaden Wähler

(K)

33

30

(CB)

5

F

(CB)

1 Bit-Register

26

25

1 × 6 Bit Speicher — 22

5 × 6 Bit Speicher

21

(CB)

6

(K)   (n)

23

(CB)   Codierer   (j)

24

FIG.2

0 067 925

$D_5$   $D_4$   $D_3$   $D_2$   $D_1$   Übertrag   $D_0$

$X \quad 10^5$   $X \quad 10^4$   $X \quad 10^3$   $X \quad 10^2$   $X \quad 10^1$   $X \quad 10^0$

19   18

$q_4^5 \, q_3^5 \, q_2^5 \, q_1^5 \, q_0^5$   $q_4^1 \, q_3^1 \, q_2^1 \, q_1^1 \, q_0^1$   $q_4^0 \, q_3^0 \, q_2^0 \, q_1^0 \, q_0^0$

$q_4^5 \, q_3^5 \, q_2^5 \, q_1^5 \, q_0^5$
Speicher   Speicher   Speicher   Speicher   $q_4^1 \, q_3^1 \, q_2^1 \, q_1^1 \, q_0^1$   $q_4^0 \, q_3^0 \, q_2^0 \, q_1^0 \, q_0^0$
Speicher   Speicher

$A_5$   $A_4$   $A_3$   $A_2$   $A_1$   5 Bit-Wort   $A_0$

FIG. 3

0 067 925

| $Q_4$ | $Q_3$ | $Q_2$ | $Q_1$ | $Q_0$ | Z |
|---|---|---|---|---|---|
| L | L | L | L | L | 0 |
| L | L | L | L | 0 | 1 |
| L | L | L | 0 | 0 | 2 |
| L | L | 0 | 0 | 0 | 3 |
| L | 0 | 0 | 0 | 0 | 4 |
| 0 | 0 | 0 | 0 | 0 | 5 |
| 0 | 0 | 0 | 0 | L | 6 |
| 0 | 0 | 0 | L | L | 7 |
| 0 | 0 | L | L | L | 8 |
| 0 | L | L | L | L | 9 |

# FIG.4

| n \ K | 0 | 1 | 2 | 3 | 4 | 5 |
|---|---|---|---|---|---|---|
| 0 | 0 | 1 | 2 | 3 | 4 | 5 |
| 1 | 1 | 2 | 3 | 4 | 0 | 5 |
| 2 | 2 | 3 | 4 | 0 | 1 | 5 |
| 3 | 3 | 4 | 0 | 1 | 2 | 5 |
| 4 | 4 | 0 | 1 | 2 | 3 | 5 |

j

# FIG.5